(19) Europäisches Patentamt
European Patent Office
Office européen des brevets

(11) Numéro de publication: **0 122 822**
**B1**

(12) **FASCICULE DE BREVET EUROPÉEN**

(45) Date de publication du fascicule du brevet: **13.01.88**

(51) Int. Cl.⁴: **H 01 L 21/316**, H 01 L 21/20

(21) Numéro de dépôt: **84400423.4**

(22) Date de dépôt: **02.03.84**

(54) **Procédé de fabrication d'un dispositif semi-conducteur du type comprenant au moins une couche de silicium déposée sur un substrat isolant.**

(30) Priorité: **11.03.83 FR 8304051**

(43) Date de publication de la demande: **24.10.84 Bulletin 84/43**

(45) Mention de la délivrance du brevet: **13.01.88 Bulletin 88/2**

(84) Etats contractants désignés: **DE FR GB IT NL**

(56) Documents cité:
**APPLIED PHYSICS LETTERS, vol. 36, no. 6, 15 mars 1979, pages 403-405, American Institute of Physics, New York, US; Y. AMAMOTO et al.: "Gettering effect by oxygen implantation in SOS"**
**JOURNAL OF THE ELECTROCHEMICAL SOCIETY, SOLID-STATE SCIENCE AND TECHNOLOGY, vol. 130, no. 8, août 1983, pages 1752-1758, Manchester, New Hampshire, US; H.M. MANASEVIT et al.: "Si on cubic zirconia"**
**THIN SOLID FILMS, vol. 95, no. 4, septembre 1982, pages 309-314, Elsevier Sequoia, Lausanne, CH; G. PERRIERE et al.: "Observation of short-range oxygen migration and oxygen exchange during low temperature plasma anodization of silicon through thin ZrO2 films"**
**JAPANESE JOURNAL OF APPLIED PHYSICS, vol. 20, no. 12, décembre 1981, pages 909-912, Tokyo, JP; Y. IRITA et al.: "Multiple SOI structure fabricated**

(73) Titulaire: **THOMSON- CSF, 173, Boulevard Haussmann, F-75379 Paris Cédex 08 (FR)**

(72) Inventeur: **Croset, Michel, THOMSON- CSF SCPI 173, bld Haussmann, F-75379 Paris Cedex 08 (FR)**
Inventeur: **Dieumegard, Dominique, THOMSON-CSF SCPI 173, bld Haussmann, F-75379 Paris Cedex 08 (FR)**
Inventeur: **Pribat, Didier, THOMSON- CSF SCPI 173, bld Haussmann, F-75379 Paris Cedex 08 (FR)**

(74) Mandataire: **Lepercque, Jean, THOMSON- CSF SCPI 19, avenue de Messine, F-75008 Paris (FR)**

(56) Documents cité: (suite)
**by high dose oxygen implantation and epitaxial growth"**

EP 0 122 822 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1988

**Description**

La présente invention concerne des dispositifs semi-conducteurs fabriqués selon la technologie de réalisation de composant ou de circuit intégré à partir de couche mince monocristaline de silicium déposées sur un substrat isolant. De nombreuses études ont été faites, notamment depuis quinze ans environ, pour arriver à la maitrise de cette technologie. Les avantages qui en sont escomptés sont dans la théorie, multiples. On peut citer, par exemple, les avantages suivant:

- Les composants ou parties de circuits réalisés dans la couche mince sont aisément isolés électriquement les uns des autres, par découpe chimique, au lieu de l'être par des couches diélecliques (en général de la silice) ou des jonctions p/n, comme c'est le cas pour les technologies traditionnelles à base de silicium massif. Le fait de supprimer l'isolement par jonction augmente considérablement la résistance aux radiations ionisantes en diminuant le nombre de paires électron-trou actives créées qualité essentielle pour l'électronique placé dans un environnement sévère.
- La capacité parasite de connexion entre composants actifs dûe au substrat diélectrique massif est très faible, favorisant ainsi la conception de circuit en logique rapide ou des circuits hyperfréquences. De plus, les capacités de jonction sont aussi supprimées.
- La technologie sur substrat isolant est plus simple que celle utilisant le silicium monocristallin massif. C'est ainsi qu'un circuit intégré selon cette technologie peut être réalisé en mettant en oeuvre un processus n'exigeant que six à huit niveaux de masquage; un circuit équivalent en technologie traditionnelie nécessite seize à vingt niveaux de masquage. De plus le gain en surface est estimé à environ 30 %.
-enfin, dans les structures du type CMOS sur silicium massif, le problème connu sous le nom anglo-saxon de "latch-up effect", c'est à dire l'apparition d'un tansistor bipolaire parasite, peut aussi être éliminé par l'emploi d'un substrat isolant.

Dans l'art connu, deux types de substrats isolants ont été testés: les substrats amorphes et les substrats monocristallins. Dans le premier cas, la cristallision monocristalline du silicium déposé est favorisée, soit par un ou des germes, soit par la définition d'un réseau de lignes parallèles en surface du substrat, imposant une orientation cristallographique préférentielle (technique dite de "graphoépitaxie").

Si l'orientation cristallographique n'est pas obtenue au moment du dépôt elle peut l'être par traitement ultérieur: recuit, avec ou sans refusion de la couche de silicium déposé par exemple.

Dans l'état du développement de la technologie, cette approche a permis l'obtention de zones monocristallines de quelques milimètres carrés de surface. Il a même pû être obtenu des zones cristallisées de quelques centimètres carrés ne comportant seulement que des sous-joints de grains qui ne semblent pas avoir une influence déterminante sur les propriétés électriques du matériau ou des structures réaliées. C'est le cas notamment des structures "MOSFET".

Dans le second cas, des substrats isolants monocristallins servent de germes cohérents à la croissance de la couche. Celle-ci est donc monocristalline dans son ensemble.

Les conditions que doivent satisfaires les substrats sont de nature physique : en particulier, maille cristalline et coefficient de dilatation voisin de ceux de la couche, et chimique: stabilité thermique et absence de réactivité avec la couche et l'environnement c'est a dire concrètement avec l'atmosphère règnant dans l'enceinte du reacteur permettant la fabrication.

En vue de la croissance de couche mince de silicium, plusieurs substrats ont été testés tels que quartz, spinelle, corindon ou saphir. Seul ce dernier à donné lieu à un développement industriel. La technologie est connue sous le nom anglo-saxon de "SOS" ("silicon on sapphire"), c'est à dire "silicium sur saphir". En effet bien que d'un point de vue qualité électrique de l'interface substrat-couche, le quartz est théoriquement préférable, d'un point de vue cristallographique, le silicium déposé sur quartz est de très mauvaise qualité. A l'expérience, le corindon est apparu meilleur que le spinelle ($Al_2$ $O_3$ MgO). Toutefois, les caractéristiques électriques des structures de type "SOS" sont médiocres: dopage incontrôlé et instable thermiquement mobilité faible et vitesse de recombinaison interfaciale élevée. Ces effets limitent les performances des circuits "SOS", en particulier pour les circuits bipolaires et pour les applications hyperfréquences. Ces circuits ne restent intéressants que lorsqu'ils sont utilisés en temps que circuits dits "durcis" c'est à dire insensibles aux rayonnements ionisants.

Les qualités médiocres des circuits de types "SOS" peuvent s'expliquer par la nature de l'interface alumine-silicium. Cet interface n'est pas parfaite d'un point de vue électrique. Une grande densité d'état d'interface existe et modifie la conductivité de la zone interfaciale. Une faible densité de charge d'interface, typiquement inférieure à $10^{11}$ par $cm^2$, est souhaitable. En outre, l'alumine à tendance à être réduite par le silane en présence d'hydrogène, et par la suite, la couche de silicium contient des quantités non négligeable d'aluminium, plus ou moins oxydé, qui peuvent devenir électriquement actives se plaçant en position substitutionnelle du réseau de silicium. Des considérations de coût rentrent également en ligne de compte, car le prix d'un substrat en saphir est relativement élevé par rapport au substrat conventionnel, même si ce surcoût est en partie compensé par la plus grande simplicité de fabrication du circuit, comme il a été rappelé précédemment.

De l'expérience acquise par les études précitées, l'enseignement suivant peut en être tiré: les avantages théoriques de cette technologie ne seraient exploitables industriellement que si :

-les propriétés électriques de la couche de silicium correspondent à celles du matériau massif, borné par deux surfaces idéales proches;

-les étapes de la technologie traditionnelle sur silicium massif permettant d'obtenir des circuits à très hautes densité d'intégration sont applicables dans le cadre de la technologie de dépôt sur substrat isolant sans altération des propriétés du silicium massif.

Du point de vue pratique, celà ce traduit par les exigences suivantes:

-le substrat doit être inerte chimiquement vis à vis des atmosphères de traitement et vis à vis du silicium, ce jusq'à des témperatures au moins égales 1050° C.

-le coefficient de dilatation du substrat, au moins dans une zone proche de l'interface, doit être adapté à celui du silicium.

- il doit être créé une couche de silice entre les couches de silicium déposé et le substrat isolant cet interface silicium-silice, étant dans l'état desconnaissances actuelles, reconnu comme un des seuls assurant une bonne qualité électrique.

Cette dernière exigence ne peut être remplie par un procédé qui consisterait simplement à créer, successivement, une couche de silice continue sur le substrat isolant puis une ou des couches de silicium. Dans ces conditions, les couches et les interfaces créés seraient de qualité médiocre, d'un point de vue caractéristiques cristallographiques et électriques.

Il apparaît que l'approche clasique mise en oeuvre dans l'art connu ne permet pas de satisfaire simultanément ces trois points.

En outre il a été constaté que lors du retour à la température ambiante, après traitement thermique ou traitement plasma, il y avait apparition des défauts étendus pendant de cette phase de refroidissement qui sont dû essentiellement à une adaptation imparfaite des paramètres de dilatation du substrat et du silicium.

Selon un aspect important de l'invention, l'étape d'oxydation de la couche de silicium est réalisée concurrement au refroidissement des matériaux.

L'invention se fixe pour but de répondre à ce besoin et propose un procédé de fabrication permettant de satisfaire ces conditions et fournissant des couches de silicium de bonne qualité électrique, couche restant compatible avec le restant de la technologie sur silicium massif et permettant l'obtention de circuit à très haute densité d'intégration.

L'invention à donc pour objet un procédé de fabrication d'un dispositif semiconducteur comprenant une étape de dépôt d'au moins une couche de silicium monocristallin sur un substrat plan en matériau isolant, comprenant une étape ultérieure de formation par oxydation d'une couche enterrée de silice d'épaisseur déterminée au sein dela couche de silicium monocristallin, l'une des faces de la couche de silice étant en contact direct avec l'une des faces du substrat dans lequel le substrat est en matériau monocristallin sélectionné parmi ceux présentant une topologie de réseau cristallin du même type que celui du silicium et chimiquement inerte vis à vis du silicium et de matériaux utilisé pour le dépôt de ladite couche de silicium et dans lequel l'étape de dépôt comprenant un traitement thermique à température plus élevée que la température ambiante, l'étape ultérieure d'oxydation s'effectue à la suite de ce traitement pendant le temps nécessaire au retour à la température ambiante, le matériau composant le substrat étant choisi parmi ceux présentant une conduction ionique exclusive de l'ion oxygène et l'étape de formation de la silice est réalisée par oxydation du silicium au travers du matériau formant le substrat dans la région en contact avec la surface du substrat sur ladite épaisseur déterminée.

L'invention sera mieux comprise et d'autres avantages apparaîtront à la lecture de la description ci-après en se référant aux dessins annexés parmi lesquels:

-les figures 1 à 3 illustrent les étapes principales du procédé de dépôt d'une couche de silicium sur un substrat isolant selon l'invention.

-les figures 4 à 5 illustrent trois variantes du procédé selon l'invention.

Le procédé selon l'invention comprend les deux dispositions suivantes:

a) Le choix d'un substrat monocristallin assurant la croissance d'une couche silicium pur ou dopé, parfaite d'un point de vue cristallographique, pure d'un point de vue chimique, c'est à dire ne contenant que du silicium et des dopants volontairement introduits pendant la croissance et présentant un interface abrupt avec substrat isolant.

b) La réalisation à postériori d'une couche mince de silice à l'interface substrat-silicium ; cette disposition étant la caractéristique principale du procédé selon l'invention. Cette couche assure la qualité électrique de l'interface et permet l'adaptation des coefficients de dilatation entre le substrat et le silicium. De plus elle élimine éventuellement une zone défectueuse de l'interface primitif silicium-substrat. Elle permet l'utilisation de technologies traditionnelles mises en oeuvre pour le dépôt sur silicium massif même celles nécessitant des traitements à hautes températures. En outre la réalisation de cette couche est réalisée pendant le retour à la température ambiante après l'étape de dépôt.

Le substrat est choisi conducteur ionique de l'oxygène à température modérée; c'est à dire de façon pratique à une température inférieure ou égale à 1200° C, afin de permettre par oxydation du silicium au travers du substrat la création de la couche de silice.

Les figures 1 à 3 illustrent les principales étapes du procédé selon l'invention.

Sur la figure 1, est représenté le substrat nu 1, préparé et nettoyé par toutes techniques appropriées communes à l'art connu.

Sur la figure 2, une couche de silicium pur ou dopé 2 est déposée également selon les techniques classiques de l'art connu sur le substrat.

Selon la caractéristique principale de l'invention, une couche de silice 12 est créée au sein de la couche de

silicium, comme illustré à la figure 3, formant une couche intermédiaire entre la partie supérieure dela couche de silicium déposée qui reste inchangée et le substrat isolant 1.

Le procédé comprend deux variantes principales: la création d'une couche de silice peut s'effectuer par oxydation thermique ou plasma de l'interface substrat-silicium déposé.

Selon toutes ces variantes, on choisit pour constituer le substrat un matériau satisfaisant aux conditions précédemment énoncées et conducteur ionique de l'oxygène à température modérée, c'est à dire inférieure ou égale à 1200°C, afin de permettre la création d'une couche de silice par oxydation du silicium au travers du substrat.

Un exemple de matériau convenant parfaitement à cet usage est la zircone dopée, par exemple à l'oxyde d'yttrium de formule:

$$(Zr\,O_2)_{1-x}(Y_2O_3)_{x/2}$$

tel que celui étudié dans l'article "Si on Cubic Zirconia"de H.M. Manasevit et al publié dans Journal of the Electrochemical Society, Solid-State Science and Technology volume 130, numéro 8, d'Août 1983, pages 1752 à 1758.

Le dopage peut être réalisé également à l'aide d'oxyde de calcium (Ca O).

Les caractéristiques de ce matériau sont les suivantes:

-La maille cristalline est cubique, comme celle du silicium et proche de celui-ci. En outre, le paramètre cristallin est ajustable par dopage. La maille du silicium a des dimensions égales à 5,43 angströms; celle de la zirconium selon le dopage, varie entre 5,14 angströms et 5,21 angströms.

- La zircone est chimiquement inerte vis à vis des atmosphères usuellement utillisés lors des dépôts et vis à vis du silicium, ce jusqu'à des températures très élevées.

- Le coefficient de dilatation linéaire de la zircone est proche de celui du silicium et également ajustable par dopage. Pour fixer les idées le coefficient de dilatation linéaire 1/1 du silicium = $3.10^{-6}$ par °C et celui de la zircone typiquement égal à $8.10^{-6}$ par °C.

- Enfin, la zircone est conductrice ionique de l'oxygène à température modérée.

Il peut être utile de noter que le dopage ne permet pas l'optimisation simultané des deux paramètres "coefficient de dilatation" et "maille cristalline ajuste". Selon la technologie d'oxydation adoptée, c'est à dire la variante choisie, on privilégira l'un ou l'autre de ces paramètres comme il sera indiqué dans ce qui suit.

Le procedé selon l'invention comprend, commune aux deux variantes, une étape de dépôt sur un substrat préalablement préparée d'au moins une couche de silicium intrinsèque ou dopé. Cette étape peut être réalisée selon plusieurs variantes par des techniques classiques de l'art connu. Une première technique est le dépôt par la méthode "CVD"("dépôt chimique sous phase vapeur"). Pour ce faire, le substrat est placé dans un réacteur dans lequel régne une température élevée de l'ordre de 700°C à 1200°C. A la suite de la phase de dépôt on obtient directement une couche de silicium monocristallin. Une deuxième technique utilisable est l'évaporation ou la pulvérisation cathodique. On obtient alors une couche de silicium polycristallin et il est nécessaire de faire suivre cette étape par une étape de réorganisation cristallographique en phase solide ou liquide (traitement thermique, irradiation de lumière cohérente ou incohérente, fasceau d'électrons...) permettant d'obtenir le silicium monocristallin. Enfin, une trosième technique utilisable de dépôt dit "M.B.E"(" molecular beam epitaxy"). Comme dans le cas du dépôt "CVD" on obtient directement une couche de silicium monocristallin.

A la suite de cette opération de dépôt on obtient donc une couche de slicium monocristallin 2 sur un substrat 1, de façon préférentielle un substrat en zircone dopée. A titre d'exemples non limitatifs, le substrat typiquement une epaisseur comprise entre 300 µm et 1 mm et la couche de silicium une épaisseur inférieure ou égale à 1 µm et supérieure à quelques dizaines de nm.

Suite à cette opération de dépôt on va créer à l'interface silicium 1- substrat 2 une mince couchede silice 12 par oxydation du silicium au niveau de cet interface.

Selon la première variante, on procède par oxydation thermique. Pour ce faire, on place l'ensemble des deux couches 1 et 2 dans un four illustré schématiquement par la référence 3 sur la figure 4. Dans ce four on introduit de l'oxygène ou tout simplement de l'air ou toute atmosphère non réactive contenant de l'oxygène, à pression normale soit 1 atm (101 325 Pa). La cinétique d'oxydation étant limitée par le transport de l'oxygène au travers de la silice en formation, la température doit être suffisamment élevée pour que la durée du traitement ne soit pas excessive, typiquement la température est choisie dans une gamme 900 à 1200°C. A l'interface entre le gaz oxygène ou l'air et le substrat, les molécules d'oxygène se dissocient et diffusent au travers du substrat en zircone dopé 1 jusqu'à l'interface zircone silicium 2 pour y oxyder le silicium et former une mince couche de silice 12. Celle-ci ne perturbe en rien la couche de silicium monocristallin déjà formée. Il s'y forme alors, selon la caractéristique principale de l'invention, un interface silicium-silice abrupt ayant les qualités précédemment ennoncées.

Selon cette variante, la température de traitement étant élevée, il est nécessaire de privilégier le paramètre "dilatation" par rapport au paramètre "maille cristalline ajustée". En effet, des expériences sur d'autres matériaux tel que le corindon ont montré que l'identité du paramètre de maille entre le substrat et la couche n'était pas absolument idispensable à la croissance monocristalline.

Selon une seconde variante, illustrée par la figure 5, la création de la couche de silice s'effectue par oxydation anodique plasma. Celle-ci s'effectue à température modérée, typiquement entre 300°C et 450°C.

Selon cette variante, il convient de privilégier le paramètre de "maille cristalline ajustée" pour adapter au mieux les deux réseaux et assurer la perfection cristalline. Il est à remarquer que, de toute façon, après croissance de la couche de silice, l'adaptation des coefficents de dilatation entre les couches de silicum et le substrat est assurée par la couche de silice qui est de type amorphe, donc très facilement délormable. La structure silicium sur substrat isolant ainsi obtenue est compatible avec les technologies sur silicium massif, même avec celles nécessitant des traitements thermiques élevés, supérieur ou égal à 1200° C.

Sur la figure 5 est représenté un appareillage 4 permettant le traitement plasma pour obtenir l'oxydation et la création d'une couche de silice selon la seconde variante. Cet appareillage 4 comprend typiquement:

-une plaque 41 de molybdène ou de silice fondu, qui est utilisé comme support de l'empilement "1, 12,2" à traiter;

- un thermocouple 42 que l'on dispose sur le support 41 au voisinage immédiat des couches à traite. Ce thermocouple est destiné à contrôler la température pendant le traitement.

- une enceinte 43 constituée, par exemple, par un tube 431 en silice fondue, fermé au extrémités par des embouts 432 et 433 et traversé par un tube 44 de plus faible diamètre que le tube 431. Ce tube est destiné à faire circuler un courant gazeux dans l'enceinte. Le gaz est soit un gaz pur c'est à dire de l'oxygène soit un mélange gazeux d'oxygène et de gaz rare, par exemple de l'argon. A l'autre extrémité du tube 431, est disposée une canalisation 48 de raccordement à une pompe à vide représenté symboliquement par une flèche marquée P, cette pompe est capable de maintenir la presson du mélange gazeux ou du gaz dans une gamme de pression typique de $10^{-1}$ à $10^{-2}$ Pascals.

- un enroulement 45 de fils conducteurs alimentés par un courant électrique haute fréquence, capable de créer un plasma dans la région de l'enceinte 43 dans laquelle est placé l'empilement de couches "1, 12, 2"

-et un système de chauffage par radiation comprenant une source 46 et un réflecteur 47 capable de réfléchir de façon sensiblement uniforme les radiations produites par la source 46 sur une surface de l'ordre de celle de la couche à traiter.

Comme il a été indiqué, selon un aspect important de l'invention et dans les deux variantes de réalisation l'étape d'oxydation localisée de la couche de silicium est réalisée pendant la période nécessaire au refroidissement après l'étape de dépôt. Ceci permet d'éliminer en grande partie la formation de défauts étendus pendant cette phase de refroidissement qui sont dus essentiellement à une adaptation imparfaite des paramètres de dilatation du substrat et du silicium. Ces defauts peuvent se comporter ultérieurement comme des courts-circuits de diffusion de l'oxygène. Il en résulte alors une couche d'oxyde mal définie en épaisseur, pouvant donner naissance à des densités d'états d'interfaces élevées et rédhibitoires. Comme il a été rappelé, on s'efforce d'obtenir des densités de charges d'interface inférieures ou égales à $10^{11}$ par $cm^2$. Par cette méthode, on obtient le plus rapidemment possible une couche interfaciale apte à subir des contraintes dû au traitement thermique y compris les contraintes du premier refroidissement.

A titre d'illustration plus complète du procédé de l'invention, des données typiques selon les deux variantes décristes sont résumées dans un tableau placé en fin dela présente description.

A.1 Oxydation thermique du silicium

| Atmosphère | T °C | temps | épaisseur d'oxyde Si $O_2$ |
|---|---|---|---|
| Oxygène humide | 1200° C | 20 mn | 5000 Å |
| 5 Oxygène sec | 1200° C | 4h | 5000 Å |

A.2 Oxydation plasma du silicium

| Plasma | T° C | temps | tension d'oxydation | épaisseur d'oxyde $SiO_2$ |
|---|---|---|---|---|
| Oxygène | 120° C | 3 mn | 170v | 1000 Å |

**Revendications**

1. Procédé de fabrication d'un dispositif semiconducteur comprenant une étape de dépôt d'au moins une couche de silicium monocristallin (2) sur un substrat plan (1) en matériau isolant le substrat étant en matériau monocristallin sélectionné parmi ceux présentant une topologie de réseau cristallin du même type que celle du silicium et chimiquement interte vis à vis du silicium et de matériaux utilisés pour le dépôt de ladite couche de silicium et le matériau composant le substrat (1) étant choisi parmi ceux présentant une conduction ionique exclusive de l'ion oxygène, caractérisé en ce qu'il comprend une étape ultérieure de formation, par oxydation, d'une couche enterrée de silice d'épaisseur déterminée au sein de la couche de silicium monocristallin (2), l'une des faces de la couche de silice étant en contact direct avec l'une des faces du substrat et en ce que l'étape de dépôt comprend un traimement thermique à température plus élevée que la température ambiante, l'étape ultérieure d'oxydtion s'effectue à la suite de ce traitement pendant le temps nécessaire au retour à la température ambiante et l'étape de formation de la silice (12) est réalisée par oxydation du silicium au travers du matériau formant le substrat (1) dans la région en contact avec la surface du substrat sur ladite épaisseur

déterminée.

2. Procédé selon la revendication 1, dans lequel l'oxydation est réalisée par traitement thermique en exposant l'empilement comprenant au moins une couche de silicium (2) sur un substrat isolant (1) à une atmosphère contenant de l'oxygène pour obtenir une migration d'ions oxygène au travers de l'épaisseur du substrat (1).

3. Procédé selon la revendication 1, dans lequel l'oxydation du silicium est réalisée en exposant l'empilement constitué par au moins une couche de silicium monocristallin (2) sur un substrat isolant (1) à un plasma contenant de l'oxygène sous forme ionique de manière à obtenir la migration d'ions oxygène au travers de l'épaisseur du substrat (1).

4. Procédé selon l'une quelconque des revendications 1 à 3, caractérisé en ce que le matériau du substrat (1) est de la zircone dopée.

5. Procédé selon la revendication 4, dans lequel la zircone est dopée avec un oxyde choisi parmi l'oxyde d'ytrium ou l'oxyde de calcium.

6. Procédé selon l'une quelconque des revendications 4 ou 5, dans lequel le dopage est déterminé de façon à ajuster les dimensons élémentaires du réseau cristallin et le coefficient de dilatation associé à la zircone de manière à les adapter à ceux associés au silicium.

## Patentansprüche

1. Verfahren zur Herstellung einer Halbleiteranordnung, mit einem Verfahrensschritt, bei dem mindestens eine Schicht (2) aus monokristallinem Silizium auf ein ebenes Substrat (1) aus isolierendem und monokristallinem Material aufgebracht wird, das aus den Materialien ausgewählt ist, die eine Topologie des Kristallgitters derselben Art wie Silizium besitzen und gegenüber Silizium und den für das Aufbringen der Siliziumschicht verwendeten Materialien inert sind und eine lonenleitfähigkeit ausschließlich für Sauerstoffionen besitzen, dadurch gekennzeichnet, daß in einem späteren Verfahrensschritt durch Oxidation eine Siliziumdioxidschicht einer bestimmten Dicke eingebettet in die monokristalline Siliziumschicht (2) gebildet wird, wobei eine der Seiten der Siliziumdioxidschicht in unmittelbarem Kontakt mit einer der Seiten des Substrats steht, daß der erstgenannte Verfahrensschritt eine Wärmebehandlung bei einer über Umgebungstemperatur liegenden Temperatur umfaßt, daß der die Oxidation enthaltende Verfahrensschritt nach dieser Wärmebehandlung während einer Zeitdauer durchgeführt wird, die für die Rückkehr zur Umgebungstemperatur benötigt wird, und daß die Bildung der Siliziumdioxidschicht mittels Oxidation des Siliziums durch das das Substrat (1) bildende Material hindurch und über die bestimmte Dicke hinweg in der Zone erfolgt, die mit der Oberfläche des Substrats in Kontakt steht.

2. Verfahren nach Anspruch 1, in dem die Oxidation durch Wärmebehandlung erfolgt, indem der aus mindesten einer Siliziumschicht (2) auf einem isolierenden Substrat bestehende Stapel einer Sauerstoff enthaltenden Atmosphäre ausgesetzt wird, um eine Migration von Sauerstoffionen durch die Dicke des Substrats (1) zu erhalten.

3. Verfahren nach Anspruch 1, in dem die Siliziumoxidation erfolgt, indem der aus mindestens einer Schicht (2) monokristallinen Siliziums auf einem isolierenden Substrat (1) bestehende Stapel einem Sauerstoff in lonenform enthaltenden Plasma ausgesetzt wird, um eine Migration von Sauerstoffionen durch die Dicke des Substrats (1) zu erhalten.

4. Verfahren nach einem beliebigen der Ansprüche 1 bis 3, dadurch gekennzeichnet, daß das Material des Substrats (1) dotiertes Zirkon ist.

5. Verfahren nach Anspruch 4, dadurch gekennzeichnet, daß das Zirkon mit Yttriumoxid oder Kalziumoxid dotiert ist.

6. Verfahren nach einem beliebigen der Ansprüche 4 oder 5, in dem die Dotierung so festgelegt wird, daß die Elementarabmessungen des Kristallgitters und der dem Zirkon zugeordnete Ausdehnungskoeffizient so festgelegt werden, daß sie denen des Siliziums angepaßt sind.

## Claims

1. A method of manufacturing a semiconductor device, comprising a step in which a layer (2) of monocristalline silicon is deposited on a plane substrate (2) of insulating and monocristalline material selected from materials having a cristal lattice structure of the same type as that of silicon, this substrate material being chemically inert against silicon and against the materials used for depositing the silicon layer and being chosen among materials having an exclusive oxygen ion conduction, characterized in that it comprises a later step in which a layer of silicon dioxide is embedded by oxidation over a predetermined thickness in the monocristalline silicon layer (2), one of the faces of the silicon dioxide layer being in direct contact with one of the faces of the substrate, that the deposition step includes a heat treatment at a temperature above ambient temperature, that the later oxidation step is performed after this heat treatment for a time period necessary for the temperature to return to ambient temperature, and that the step of forming the silicon dioxide (12) is

achieved by oxidizing silicon through the material of the substrate (1) over said predetermined thickness in the zone which is in contact with the suurface of the substrate.

2. A method according to claim 1, wherein the oxidation is achieved by heat treatment, in exposing the stack comprising at least one silicon layer (2) on an insulating substrate (2), to an atmosphere containing oxygen in order to obtain a migration of oxygen ions through the thickness of the substrate (1).

3. A method according to claim 1, wherein the oxidation of silicon is achieved by exposing the stack comprising at least one layer (2) of monocristalline silicon on an insulating substrate (1), to a plasma containing oxygen in ionic form, in order to obtain the migration of oxygen ions through the thickness of the substrate (1).

4. A method according to anyone of claims 1 to 3, characterized in that the material constituting the substrate (1) is doped zirconium.

5. A method according to claim 4, wherein the zirconium is doped with either yttrium oxide or calcium oxide.

6. A method according to anyone of claims 4 or 5, wherein the doping is determined in such a way that the elementary sizes of the cristal lattice and the coefficient of expansion associated to zirconium are adjusted as to fit to those associated to silicon.

FIG.1

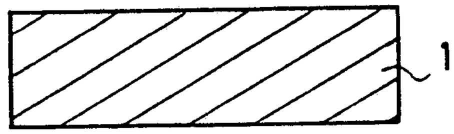


FIG.2

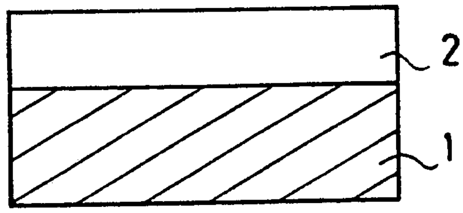


FIG.3

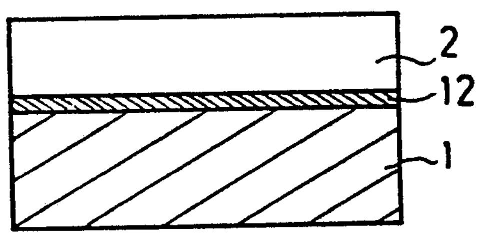


FIG.4

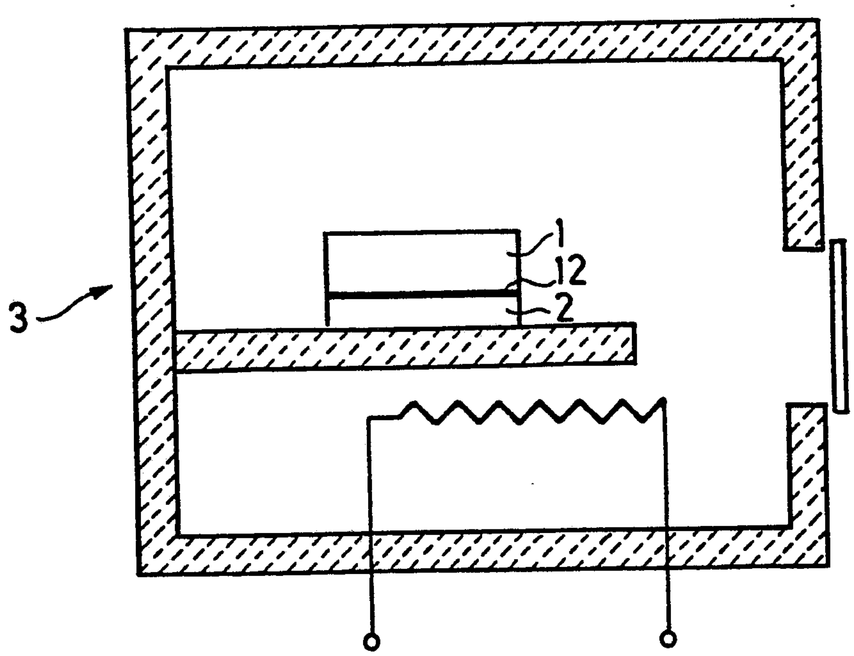

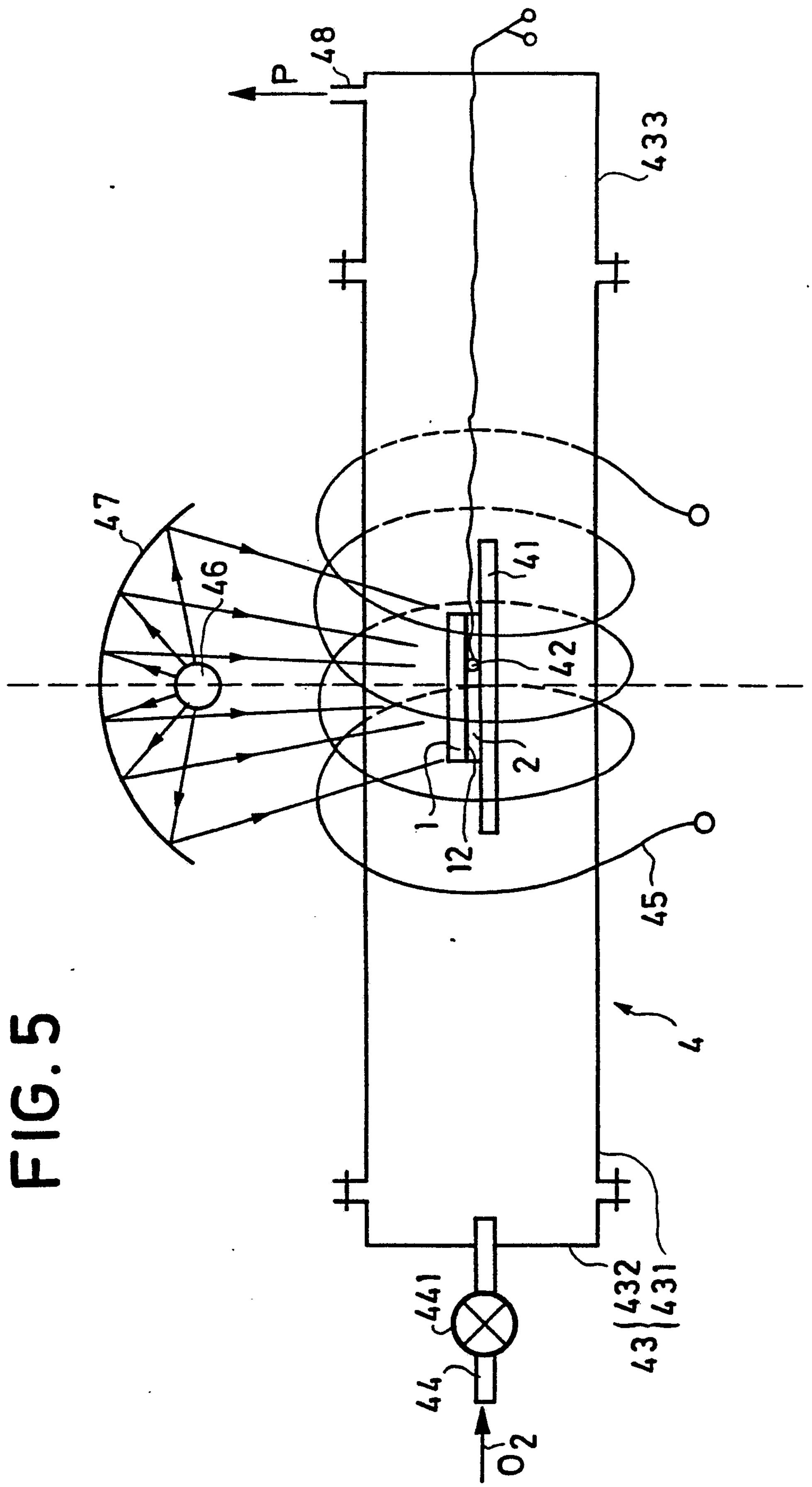


FIG. 5